(19) Europäisches Patentamt
European Patent Office
Office européen des brevets

(11) **EP 2 834 630 B1**

(12) **EUROPÄISCHE PATENTSCHRIFT**

(45) Veröffentlichungstag und Bekanntmachung des Hinweises auf die Patenterteilung:
**06.01.2016  Patentblatt 2016/01**

(21) Anmeldenummer: **13709822.4**

(22) Anmeldetag: **04.03.2013**

(51) Int Cl.:
**G01N 27/72** *(2006.01)*

(86) Internationale Anmeldenummer:
**PCT/EP2013/054230**

(87) Internationale Veröffentlichungsnummer:
**WO 2013/149776 (10.10.2013 Gazette 2013/41)**

(54) **VERFAHREN ZUR PRÜFUNG EINES BAUTEILS BASIEREND AUF BARKHAUSENRAUSCHEN**

METHOD FOR INSPECTING A COMPONENT ON THE BASIS OF BARKHAUSEN NOISES

PROCÉDÉ D'INSPECTION D'UNE PIÈCE BASÉ SUR LE BRUIT BARKHAUSEN

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **05.04.2012  DE 102012205677**

(43) Veröffentlichungstag der Anmeldung:
**11.02.2015  Patentblatt 2015/07**

(73) Patentinhaber: **ZF Friedrichshafen AG 88046 Friedrichshafen (DE)**

(72) Erfinder:
• **BLEICHER, Oliver 88045 Friedrichshafen (DE)**
• **YAKARIA, Herman 88085 Langenargen (DE)**
• **XU, Yiwen 88048 Friedrichshafen (DE)**

(56) Entgegenhaltungen:
**EP-A1- 0 100 009    EP-A2- 0 125 064 WO-A1-96/10744    WO-A2-2008/080395**

EP 2 834 630 B1

## Beschreibung

Die Erfindung betrifft ein Verfahren und eine Vorrichtung zur Prüfung eines Bauteils basierend auf Barkhausenrauschen.

Bei der industriellen Herstellung von Bauteilen können im Rahmen der Oberflächenbearbeitung Beschädigungen auftreten. Insbesondere bei der Serienfertigung von Bauteilen ist es deshalb erforderlich, mit einem geeigneten Prüfverfahren solche Schädigungen zu erkennen, so dass die geschädigten Bauteile ausgesondert werden können bzw. der Fertigungsprozess zur Vermeidung der Schädigungen angepasst werden kann.

Eine häufig auftretende Form von Oberflächenschädigungen ist sog. Schleifbrand, der z.B. beim Verzahnungsschleifen zur Erzeugung der Endkontur von verzahnten Bauteilen auftreten kann. Zur Erkennung von Oberflächenschädigungen bzw. von Schleifbrand sind aus dem Stand der Technik chemische Ätzverfahren bekannt. Im Rahmen des sog. Nitalätzens wird das zu prüfende Bauteil mit verschiedenen Säuren und Laugen behandelt, wobei nach der Behandlung über Farbveränderungen am Bauteil Oberflächenschädigungen und insbesondere Schleifbrand erkennbar wird. Das Nitalätzen ist zum einen umweltunfreundlich und verursacht zum anderen sehr hohe Kosten für die Wartung und Entsorgung der verwendeten Säuren und Laugen. Ferner ist es ein subjektives Prüfverfahren, bei dem die Oberflächenschädigung über Verfärbung durch menschliche Experten beurteilt wird. Zur Prüfung der Oberflächen von Bauteilen im Rahmen einer Großfertigung ist Nitalätzen deshalb nicht geeignet.

Aus dem Stand der Technik ist ferner die sog. Barkhausenrausch-Analyse bekannt, mit der zerstörungsfrei die Oberflächen von ferromagnetischen Materialien mittels entsprechender Sensoren geprüft werden können. In den Druckschriften EP 0 100 009 A1 und DE 43 33 830 A1 sind Verfahren zur Oberflächenanalyse unter Berücksichtigung von Barkhausenrauschen beschrieben. Die Barkhausenrausch-Analyse beruht auf den sog. Barkhausensprüngen, welche durch die Ummagnetisierung von ferromagnetischen Werkstoffen bei sich langsam erhöhender Feldstärke eines Magnetfelds entstehen. Ferromagnetische Materialien bestehen aus kleinen magnetischen Bereichen (sog. Domänen) mit einheitlichen Magnetisierungsrichtungen. Die Domänen werden voneinander durch Blochwände getrennt, in denen sich die Magnetisierungsrichtung über die Wandbreite ändert. Eine Bewegung der Blochwände kann durch ein äußeres Magnetfeld veranlasst werden. Wenn gleichzeitig eine Spule in die Nähe des ferromagnetischen Bauteils gebracht wird, erzeugt die entstehende Magnetisierung einen elektrischen Impuls in der Spule. Die Addition der Impulse ergibt ein rauschartiges Signal, welches auch als Barkhausenrauschen bzw. Barkhausenrausch-Signal bezeichnet wird. Das Barkhausenrausch-Signal hängt dabei von der Oberflächenbeschaffenheit und insbesondere von der Oberflächenhärte ab. Über das Barkhausenrausch-Signal kann Schleifbrand detektiert werden, da die Oberflächenhärte bei Schleifbrand abnimmt.

Auch wenn über die Barkhausenrausch-Analyse Oberflächenschädigungen erkannt werden können, so lassen derzeitige Analyse-Verfahren keinen Rückschluss dahingehend zu, welche Ursachen im Herstellungsprozess des Bauteils zu der Oberflächenschädigung geführt haben. Deshalb ist es wünschenswert, die Barkhausenrausch-Analyse dahingehend zu erweitern, dass Ursachen für Oberflächenschädigungen erkannt werden.

Aufgabe der Erfindung ist es deshalb, ein Verfahren und eine Vorrichtung zur Prüfung eines Bauteiles basierend auf Barkhausenrauschen zu schaffen, welche Ursachen für Bauteilschädigungen ermitteln.

Diese Aufgabe wird durch das Verfahren gemäß Patentanspruch 1 bzw. die Vorrichtung gemäß Patentanspruch 10 gelöst. Weiterbildungen der Erfindung sind in den abhängigen Ansprüchen definiert.

In dem erfindungsgemäßen Verfahren wird eine Vielzahl von Barkhausenrausch-Signalen verarbeitet, welche an Messpositionen entlang der Oberflächen des Bauteils mit einer geeigneten Messvorrichtung zur Barkhausenrausch-Analyse erfasst wurden bzw. erfasst werden. Der Schritt der Erfassung der Barkhausenrausch-Signale kann somit Teil des erfindungsgemäßen Verfahrens sein. Jedoch besteht auch die Möglichkeit, dass das erfindungsgemäße Verfahren von bereits zuvor erfassten Barkhausenrausch-Signalen ausgeht, die z.B. aus einem entsprechenden Speicher ausgelesen werden. Das erfindungsgemäße Verfahren wird rechnergestützt mittels einer Rechnereinheit ausgeführt. Dabei wird zunächst aus den Barkhausenrausch-Signalen eine Messmatrix gebildet, welche die erfassten Barkhausenrausch-Signale als Einträge enthält. Ferner ist eine Mehrzahl von Charakteristika vorgegeben, welche jeweils zumindest eine Ursache für Herstellungsfehler des Bauteils repräsentieren, wie z.B. Ursachen für Schleifbrand bzw. andere Prozessfehler während der Herstellung. Diese Mehrzahl von Charakteristika kann z.B. vorab in einem Speicher hinterlegt sein. Jeder Charakteristik ist dabei eine Verarbeitung der Messmatrix zugeordnet. Diese Verarbeitung ist spezifisch für die jeweilige Charakteristik, so dass mit der entsprechenden Verarbeitung Rückschlüsse auf Ursachen für Herstellungsfehler gemacht werden können. Schließlich wird für jede Charakteristik die Messmatrix der zugeordneten Verarbeitung unterzogen, wodurch eine Ausprägungsstärke der jeweiligen Charakteristik bestimmt wird.

Das erfindungsgemäße Verfahren beruht auf der Erkenntnis, dass Charakteristika in geeigneter Weise mit speziellen, für die jeweilige Charakteristik gültigen Verarbeitungsschritten für die Barkhausenrausch-Signale verknüpft werden können, um hierdurch Ursachen für Bauteilschädigung zu ermitteln. Im erfindungsgemäßen Verfahren werden dabei insbesondere Barkhausenrausch-Signale von Bauteilen verarbeitet, für die bereits vorbekannt ist, dass eine Oberflächenschädigung bzw. Schleifbrand vorliegt. Ausführungsbeispiele zur Spezifikation entsprechender Verarbeitungsschritte für jeweilige Charakteristika werden weiter unten näher beschrieben.

In einer besonders bevorzugten Ausführungsform wird das Verfahren zur Prüfung eines Zahnrads eingesetzt, wobei die Messpositionen, an denen die Barkhausenrausch-Signale erfasst werden oder wurden, dreidimensionale Messpositionen sind, welche die Dimensionen Zahnradumfang, Zahnprofil und Zahnradbreite umfassen. Der Zahnradumfang spezifiziert dabei Zahnflanken bzw. Zahnlücken entlang des Zahnradumfangs, das Zahnprofil betrifft Messlinien für eine Zahnlücke oder eine Zahnflanke und die Zahnradbreite spezifiziert Breitenpositionen in Richtung der Breite des Zahnrads.

In einer weiteren, besonders bevorzugten Ausführungsform definieren die jeweiligen Charakteristika eine oder mehrere der folgenden Ursachen: Rundlauffehler, einseitiges Schleifen, unbearbeitete Stellen, Aufmaßschwankungen, Härteverzüge, abweichende Bauteiloberflächenhärtewerte, Werkzeugabnutzung und dergleichen. Ggf. können auch Messfehler, wie z.B. fehlende Kontakte zwischen Messkörper und Bauteil, oder ein defekter Messsensor als Charakteristika berücksichtigt werden.

In einer bevorzugten Ausführungsform des erfindungsgemäßen Verfahrens ist die der jeweiligen Charakteristik zugeordnete Verarbeitung derart ausgestaltet, dass eine für die jeweilige Charakteristik spezifische Korrekturmatrix mit Korrekturwerten für jeden Eintrag der Messmatrix vorgegeben ist und die Summe aus den mit den Korrekturwerten multiplizierten Einträgen der Messmatrix gebildet wird, wobei die Summe eine absolute Ausprägungsstärke der jeweiligen Charakteristik darstellt. Die Korrekturwerte können je nach Ausgestaltung der Erfindung verschieden festgelegt werden. In einer bevorzugten Variante werden als Korrekturwerte die Werte Eins und Null verwendet.

In einer besonders bevorzugten Ausführungsform der Erfindung, bei der ein Zahnrad geprüft wird, werden die Korrekturwerte für die Charakteristik Rundlauffehler für alle Barkhausenrausch-Signale mit Messpositionen in einem vorbestimmten Umfangsbereich auf Eins und ansonsten auf Null gesetzt. Hierdurch wird berücksichtigt, dass Rundlauffehler in einem vorbestimmten Umfangsbereich zu Schleifbrand und somit erhöhten Barkhausenrausch-Signalen führen, welche besonders stark gewichtet werden. Für die Charakteristik einseitiges Schleifen können die Korrekturwerte derart festgelegt werden, dass sie von einer Zahnflanke zur nächsten zwischen Null und Eins wechseln und innerhalb einer Zahnflanke gleich sind. Hierdurch kann einseitiges Schleifen festgestellt werden, bei dem lediglich auf einer Zahnflanke Schleifbrand auftritt. Ebenso kann einseitiges Schleifen entlang der Breite des Zahnrads dadurch erkannt werden, dass Korrekturwerte an einem Randbereich der Breite des Zahnrads auf Eins und ansonsten auf Null gesetzt sind.

In einer weiteren Ausführungsform des erfindungsgemäßen Verfahrens umfasst die der jeweiligen Charakteristik zugeordnete Verarbeitung einen Modifikationsschritt, gemäß dem eine modifizierte Messmatrix durch die Mittelung von Barkhausenrausch-Signalen für eine Anzahl von Messpositionen entlang der Oberfläche des Bauteils bestimmt wird, wobei die Anzahl von Messpositionen für die jeweilige Charakteristik spezifisch ist. In einer bevorzugten Variante sind für die Charakteristik Rundlauffehler die Anzahl von Messpositionen, deren Barkhausenrausch-Signale gemittelt werden, ausschließlich Messpositionen betreffend die gleiche Zahnflanke oder Zahnlücke, so dass keine Mittelung über den Zahnradumfang hinweg erfolgt. Für die Charakteristik einseitiges Schleifen sind die Anzahl von Messpositionen, deren Barkhausenrausch-Signale gemittelt werden, vorzugsweise nur Messpositionen betreffend die gleiche Zahnflanke oder die gleiche Breitenposition der Zahnrandbreite. Für gemittelte Messpositionen betreffend die gleiche Zahnflanke kann unterschiedliches Schleifen der rechten und linken Zahnflanke als Charakteristik betrachtet werden. Für gemittelte Messpositionen betreffend die gleiche Breitenposition kann einseitiges Schleifen entlang der Zahnradbreite als Charakteristik betrachtet. In einer bevorzugten Ausführungsform betreffen für die Charakteristik Rundlauffehler die Messpositionen, deren Barkhausenrausch-Signale gemittelt werden, unterschiedliche Messlinien mit der gleichen Breitenposition der Zahnradbreite und betreffend die gleiche Zahnflanke.

In einer weiteren, besonders bevorzugten Ausführungsform umfasst die der jeweiligen Charakteristik zugeordnete Verarbeitung neben dem oben beschriebenen Modifikationsschritt einen Verarbeitungsschritt, gemäß dem die Einträge der modifizierten Messmatrix diskretisiert werden und eine Cooccurence-Matrix für die Häufigkeiten von Wertekombinationen benachbarter Einträge der modifizierten und diskretisierten Messmatrix bestimmt wird, wobei die Cooccurence-Matrix mit einer Gewichtungsmatrix multipliziert wird, welche große Änderungen in den Werten benachbarter Einträge der modifizierten und diskretisierten Messmatrix höher gewichtet, wobei die Determinante des Multiplikationsergebnisses bestimmt wird. Diese Determinante stellt eine absolute Ausprägungsstärke für die jeweilige Charakteristik dar. In dieser Ausführungsform macht man sich die Erkenntnis zunutze, dass Charakteristika sehr gut über starke Schwankungen von Barkhausenrausch-Signalen entlang der Bauteiloberfläche detektiert werden können. Diese starken Schwankungen werden in an sich bekannter Weise mit einer aus der Bildverarbeitung bekannten Cooccurence-Matrix beschrieben, welche auch als Grauwertematrix bezeichnet wird. Diese Matrix wird nunmehr statt für Grauwerte von Bildern für entsprechende Werte von Barkhausenrausch-Signalen verwendet.

In den oben beschriebenen Ausführungsformen, welche eine absolute Ausprägungsstärke der jeweiligen Charakteristik ermitteln, wird vorzugsweise aus der absoluten Ausprägungsstärke eine relative Ausprägungsstärke bestimmt, indem die absolute Ausprägungsstärke der jeweiligen Charakteristik durch die Summe der absoluten Ausprägungsstärken aller Charakteristika geteilt wird.

Neben dem oben beschriebenen Verfahren betrifft die Erfindung ferner eine Vorrichtung zum Prüfen eines Bauteils basierend auf Barkhausenrauschen unter Verwendung einer Vielzahl von Barkhausenrausch-Signalen, welche an Messpositionen entlang der Oberfläche des Bauteils mit einer Messvorrichtung erfasst wurden oder werden. Die erfindungsgemäße Vorrichtung beinhaltet eine Rechnereinheit, welche derart ausgestaltet ist, dass in deren Betrieb aus den Barkhausenrausch-Signalen eine Messmatrix gebildet wird, welche die erfassten Barkhausenrausch-Signale als Einträge enthält. Mittels der Rechnereinheit wird ferner eine Mehrzahl von Charakteristika vorgegeben, welche jeweils zumindest eine Ursache für Herstellungsfehler des Bauteils repräsentieren, wobei jeder Charakteristik eine Verarbeitung der Messmatrix zugeordnet ist, wobei die Verarbeitung spezifisch für die jeweilige Charakteristik ist. Schließlich wird für jede Charakteristik die Messmatrix der zugeordneten Verarbeitung unterzogen, wodurch eine Ausprägungsstärke der jeweiligen Charakteristik bestimmt wird.

Die erfindungsgemäße Vorrichtung ist vorzugsweise derart ausgestaltet, dass eine oder mehrere Varianten der oben beschriebenen bevorzugten Ausführungsformen des erfindungsgemäßen Verfahrens mit der Vorrichtung durchführbar sind. Die Vorrichtung kann ggf. Teil der Messvorrichtung sein, mit der die arkhausenrausch-Signale erfasst werden. Ebenso kann die Vorrichtung eine separate Auswerteeinheit für Barkhausenrausch-Signale darstellen.

Ausführungsbeispiele der Erfindung werden nachfolgend anhand der beigefügten Figuren detailliert beschrieben.

Es zeigen:

Fig. 1 eine schematische Darstellung eines Messvorgangs basierend auf Barkhausenrauschen für ein Zahnrad;

Fig. 2 eine graphische Darstellung einer Messmatrix aus Barkhausenrausch-Signalen, welche in einer Ausführungsform des erfindungsgemäßen Verfahrens verarbeitet wird;

Fig. 3 eine graphische Darstellung einer Korrekturmatrix für die Charakteristik eines Rundlauffehlers, welche in einer Ausführungsform des erfindungsgemäßen Verfahrens verarbeitet wird;

Fig. 4 eine schematische Darstellung einer Modifikation der ursprünglichen Messmatrix, welche in einer Ausführungsform des erfindungsgemäßen Verfahrens durchgeführt wird; und

Fig. 5 eine schematische Darstellung, welche die Erzeugung einer Cooccurrence-Matrix verdeutlicht, die in einer Ausführungsform des erfindungsgemäßen Verfahrens verarbeitet wird.

Nachfolgend wird das erfindungsgemäße Verfahren basierend auf der Oberflächenprüfung von Bauteilen in der Form von Zahnrädern erläutert. Nichtsdestotrotz ist die Erfindung auch für beliebige andere Bauteile anwendbar. Im Rahmen der Herstellung der Zahnräder wurde dabei mittels Verzahnungsschleifen die Endkontur der Zahnräder erzeugt. Bei diesem Schleifvorgang wird das Aufmaß durch Schleifkörner zerspant. Dadurch können sich die lokalen Temperaturen an den Kontaktzonen so stark verändern, dass thermische Gefügeänderungen auftreten. Diese thermischen Gefügeänderungen werden häufig als Schleifbrand bezeichnet. Schleifbrand entsteht unter anderem bei der Übersteigung der bauteilspezifischen Anlasstemperatur und tritt in der Form von Anlassschädigung auf, wobei die Härte der betroffenen Stelle am Bauteil sinkt. Bei einer drastischen Temperaturerhöhung und mit einem anschließenden Abkühlen durch Kühlschmiermittel entsteht eine härtere Oberfläche. Diese Form von Schleifbrand wird auch als Wiederhärtung bezeichnet.

In der hier beschriebenen Ausführungsform werden zunächst Barkhausenrausch-Signale von Zahnrädern mittels einer Messvorrichtung erfasst. Die Messvorrichtung ist dabei geeignet kalibriert, so dass geschädigte Bauteile mit Schleifbrand anhand der Messwerte erkannt erden. Die erfassten Messwerte von geschädigten Bauteilen werden anschließend einer Auswertung unterzogen, um die wahrscheinlichsten Ursachen für den Schleifbrand bzw. Prozessfehler bei der Herstellung des Bauteils aufzufinden. Wie bereits eingangs erläutert, wird Barkhausenrauschen dadurch gemessen, dass ein äußeres Magnetfeld an entsprechenden Stellen der Oberfläche des gerade geprüften Bauteils angelegt wird. Über eine Spule aus leitfähigem Draht erzeugt die entstehende Magnetisierung dabei einen elektrischen Impuls in der Spule, der von der Oberflächenhärte abhängt. Durch die Addition der elektrischen Impulse $x_i$ erhält man ein rauschartiges Signal. Dabei wird in der Regel der Effektivwert des Barkhausen-Signals als Messwert benutzt, der sich aus folgender Formel ergibt:

$$mp = \sqrt{\frac{1}{n}\sum_{i=0}^{n-1} x_i^2} \qquad (1).$$

Die an sich bekannte Abkürzung mp repräsentiert dabei den magnetischen Parameter.

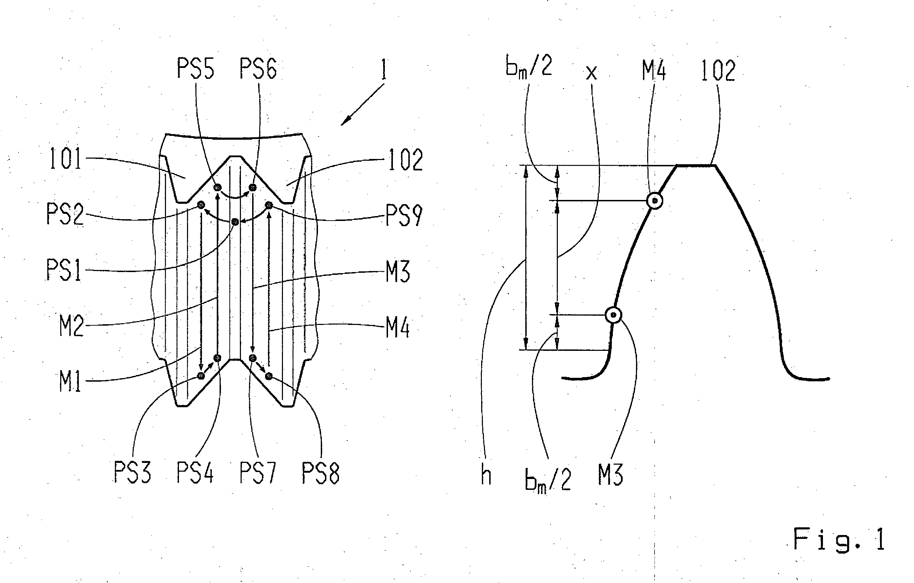

Fig. 1 verdeutlicht einen Messverlauf zur Ermittlung des Barkhausenrauschens für ein Zahnrad. Im linken Teil der Fig. 1 ist dabei in perspektivischer Darstellung eine Zahnlücke des Zahnrads wiedergegeben. Diese Zahnlücke liegt zwischen den beiden Zähnen 101 und 102, die nur teilweise dargestellt sind. Zum Messen des Barkhausenrausch-Signals wird ein entsprechender Sensorkopf der Messvorrichtung entlang Messlinien M1 bis M4 verfahren, wobei beim Verfahren kontinuierlich das Barkhausenrausch-Signal gemessen wird. Fig. 1 zeigt beispielhaft einen Messverlauf, bei dem der Messkopf ausgehend vom Punkt PS1 zunächst zum Oberflächenpunkt PS2 am Zahn 101 und dann entlang der Messlinie M1 zu Punkt PS3 verfährt. Anschließend erfolgt eine weitere Messung vom Punkt PS4 bis zum Punkt PS5 entlang der Messlinie M2. In Analogie wird für den Zahn 102 zunächst entlang der Messlinie M3 vom Punkt PS6 bis Punkt PS7 und schließlich entlang der Messlinie M4 vom Punkt PS8 bis zum Punkt PS9 gemessen. Fig. 1 zeigt dabei im rechten Teil eine Schnittdarstellung des Zahns 102. Man erkennt die senkrecht zur Blattebene verlaufenden Messlinien M3 und M4. Die Größe h stellt dabei die zur Messung nutzbare Zahnhöhe dar und durch $b_m/2$ sind die entsprechenden Abstände der Messlinien M3 bzw. M4 von dem unteren bzw. oberen Ende der nutzbaren Zahnhöhe angedeutet. Der Abstand zwischen M3 und M4 ist mit x bezeichnet.

Die Signalintensitäten des Barkhausenrauschens für gut präparierte (d.h. schmutz- und ölfreie) Bauteile werden durch die Eigenspannungen und die Härte des Bauteils beeinflusst. Beispielsweise führt eine Reduzierung der Druckeigenschaften zu einer Erhöhung der Barkhausenrausch-Amplitude. Bei Veränderung der Härte ist das Gegenteil zu beobachten, d.h. mit einer steigenden Härte nimmt die Barkhausenrausch-Amplitude ab. Über eine geeignet kalibrierte Vorrichtung kann somit aus den Barkhausenrausch-Signalen eines Bauteils auf Schleifbrand geschlossen werden. In der hier beschriebenen Ausführungsform werden nunmehr die Barkhausenrausch-Signale eines Bauteils weitergehend ausgewertet, um die Signale mit Ursachen für den Schleifbrand bzw. Prozessfehler bei der Herstellung des Bauteils zu korrelieren.

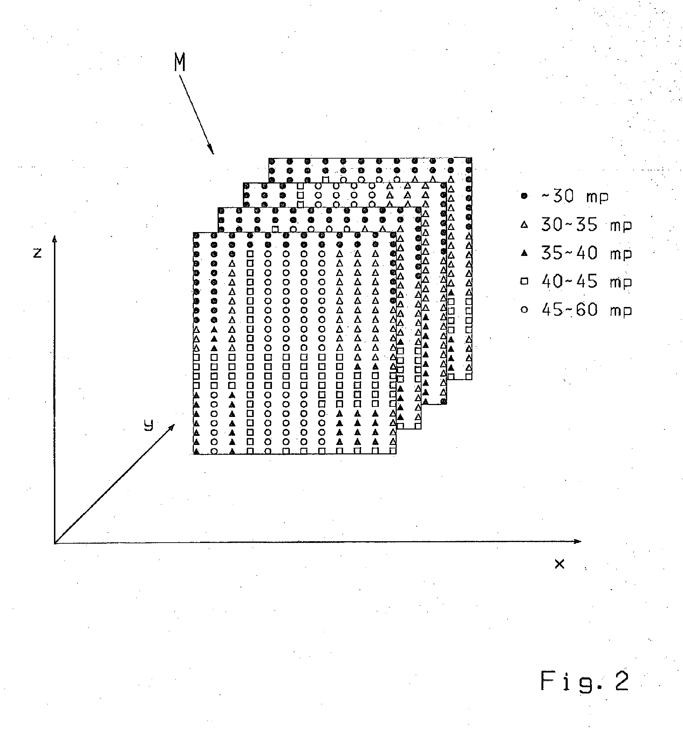

Die Auswertung der Barkhausenrausch-Signale erfolgt über eine Rechnereinheit, welche die Messwerte eines Zahnrads als Messmatrix verarbeitet. Fig. 2 zeigt dabei eine visuelle Präsentation einer solchen Messmatrix M in der Form eines dreidimensionalen Arrays aus Messpunkten. Dabei repräsentiert jeder Messpunkt eine entsprechende Position entlang der Oberfläche des Zahnrads, an der ein Barkhausenrausch-Signal ermittelt wurde. Über die Farbe bzw. Helligkeit der einzelnen Messpunkte ist dabei die Intensität des Barkhausenrausch-Signals codiert. Wie sich aus der Legende im rechten Teil der Fig. 2 ergibt, sind dabei dunklere Punkte höheren Barkhausenrausch-Signalen und hellere Punkte niedrigeren Barkhausenrausch-Signalen zugeordnet. Entsprechende Wertebereiche der Barkhausenrausch-Signale werden durch einen Farb- bzw. Helligkeitswert gemäß der Legende codiert. Gegebenenfalls können die Barkhausenrausch-Signale auch basierend auf den Wertebereichen der Legende diskretisiert werden, indem sie entsprechenden diskreten Intensitätswerten oder Klassen zugeordnet werden. In der Darstellung der Fig. 2 repräsentiert die x-Achse den Bauteilumfang des Zahnrads, wobei die in Richtung der x-Achse angeordneten vertikalen Spalten abwechselnd rechte und linke Zahnflanken des Zahnrads repräsentieren. In einer abgewandelten Ausführungsform können die einzelnen Spalten auch einer entsprechenden Zahnlücke zugeordnet sein. Die y-Achse der Fig. 2 repräsentiert das Zahnprofil in der Form der entsprechenden Messlinien pro Zahnflanke. Im Unterschied zur Darstellung der Fig. 1 werden dabei für eine Zahnflanke nicht zwei, sondern vier Messlinien betrachtet. Die z-Achse der Fig. 2 repräsentiert entsprechende Positionen entlang einer jeweiligen Messlinie und damit Breitenpositionen des Zahnrades.

Die in Fig. 2 graphisch dargestellte Messmatrix kann mathematisch wie folgt beschrieben werden:

$$M = \begin{bmatrix} x_1 & y_1 & z_1 & s_{1.1.1} \\ \cdot & \cdot & \cdot & \cdot \\ x_u & y_1 & z_1 & s_{u.1.1} \\ \cdot & \cdot & \cdot & \cdot \\ x_u & y_v & z_1 & s_{u.v.1} \\ \cdot & \cdot & \cdot & \cdot \\ x_u & y_v & z_w & s_{u.v.w} \end{bmatrix}, \qquad (1)$$

wobei $s_{u.v.w}$ die Signalintensität bei Koordinaten $[x_u, y_v, z_w]$ ist.

Die Matrix enthält für jede der in Fig. 2 gezeigten Messpositionen einen Eintrag für das Barkhausenrausch-Signal. Die Matrix kann in diesem Sinne in Bezug auf die Barkhausenrausch-Signale als ein Vektor aufgefasst werden. In einer ersten Ausführungsform der Erfindung wird die Matrix M mit einer Korrekturmatrix KM korrigiert, wobei jede Korrekturmatrix spezifisch für eine Charakteristik ist, welche eine Ursache für Schleifbrand bzw. einen Herstellungsfehler des Zahnrads darstellt. Im Folgenden werden die Charakteristika Rundlauffehler und einseitiges Schleifen näher betrachtet.

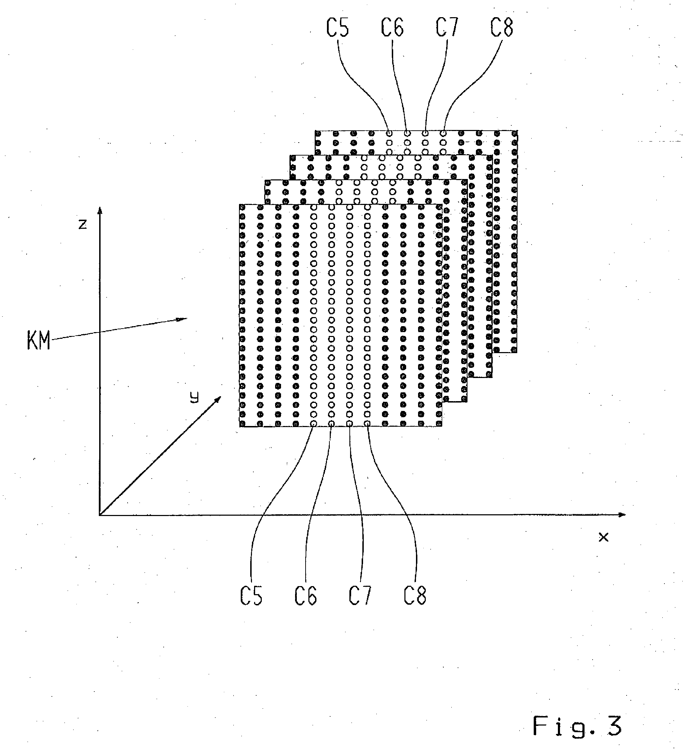

Fig. 3 zeigt eine graphische Darstellung einer Ausführungsform einer Korrekturmatrix KM für die Charakteristik Rundlauffehler. Die Matrix enthält dabei Korrekturwerte für jede der Messpositionen der Matrix M der Fig. 2. In der hier beschriebenen Ausgestaltung können die Korrekturwerte den Wert 1 und 0 annehmen. In Fig. 3 entspricht ein Korrekturwert von 1 einem dunklen Messpunkt und ein Korrekturwert von 0 einem hellen Messpunkt. Das heißt, die vertikal verlaufenden Spalten C5, C6, C7 und C8 in jeder vertikalen, parallel zur x-Achse verlaufenden Ebene der Korrekturmatrix weisen einen Korrekturwert von 1 auf, wohingegen alle anderen Korrekturwerte auf den Wert 0 gesetzt sind. Jeder Korrekturwert wird nunmehr mit dem Barkhausenrausch-Signal an der gleichen Position in der Messmatrix gemäß Fig. 2 multipliziert. Dabei ist auch zu berücksichtigen, dass die Messmatrix vorverarbeitet wurde, indem Barkhausenrausch-Signale mit den höchsten Signalintensitäten mittig in Bezug auf die x-Achse angeordnet werden. Das heißt, der Beginn der Umfangsrichtung wird derart festgelegt, dass die höchsten Barkhausenrausch-Signale bei der Hälfte des Umfangs liegen.

Durch die Multiplikation der Messmatrix mit der Korrekturmatrix wird berücksichtigt, dass bei Rundlauffehlern nur in einem vorbestimmten Umfangsbereich Schleifbrand und damit erhöhte Barkhausenrausch-Signale auftreten. Mathematisch kann die Korrekturmatrix KM wie folgt beschrieben werden:

$$KM = \begin{bmatrix} x_1 & y_1 & z_1 & Km_{1.1.1} \\ \cdot & \cdot & \cdot & \cdot \\ x_u & y_1 & z_1 & Km_{u.1.1} \\ \cdot & \cdot & \cdot & \cdot \\ x_u & y_v & z_1 & Km_{u.v.1} \\ \cdot & \cdot & \cdot & \cdot \\ x_u & y_v & z_w & Km_{u.v.w} \end{bmatrix}, \qquad\qquad (2)$$

wobei $Km_{u,v,w}$ ein Korrekturwert bei Koordinaten $[x_u, y_v, z_w]$ ist.

Die mit den entsprechenden Einträgen der Korrekturmatrix multiplizierten Barkhausenrausch-Signale der Messmatrix werden aufsummiert, wodurch ein absoluter Wert der Wahrscheinlichkeit bzw. Ausprägungsstärke der entsprechenden Charakteristik erhalten wird. Diese Ausprägungsstärke wird somit mathematisch durch folgende Gleichung beschrieben:

$$W_i = \sum_u \sum_v \sum_w s_{u.v.w} * Km_{u.v.w} \qquad\qquad (3).$$

Es wird dabei über alle Zahnflankenpositionen $x_u$, alle Messlinienpositionen $y_v$ sowie alle Zahnbreitenpositionen $z_w$ summiert, wodurch alle Einträge der Matrix M berücksichtigt werden.

In einer bevorzugten Ausführungsform wird aus der absoluten Ausprägungsstärke eine relative Ausprägungsstärke bzw. relative Wahrscheinlichkeit für die Charakteristik berechnet, indem $W_i$ durch die Summe der Ausprägungsstärken aller betrachteter Charakteristika geteilt wird. Die relative Ausprägungsstärke einer Charakteristik wird somit durch folgende Gleichung beschrieben:

$$W_{i,rel} = \frac{W_i}{\sum_{i=1}^{n} W_i} \qquad\qquad (4).$$

Dabei bezeichnet n die Anzahl der möglichen Charakteristika.

Im Falle von einseitigem Schleifen, bei dem die rechten Zahnflanken anders als die linken Zahnflanken geschliffen werden, sind die Korrekturwerte in der Matrix KM gemäß Fig. 3 anders verteilt. In diesem Fall weisen die parallel zur y- und z-Achse verlaufenden Ebenen der Korrekturmatrix abwechselnd die Korrekturwerte 0 und 1 auf. Das heißt, den rechten und den linken Zahnflanken werden unterschiedliche Korrekturwerte zugeordnet.

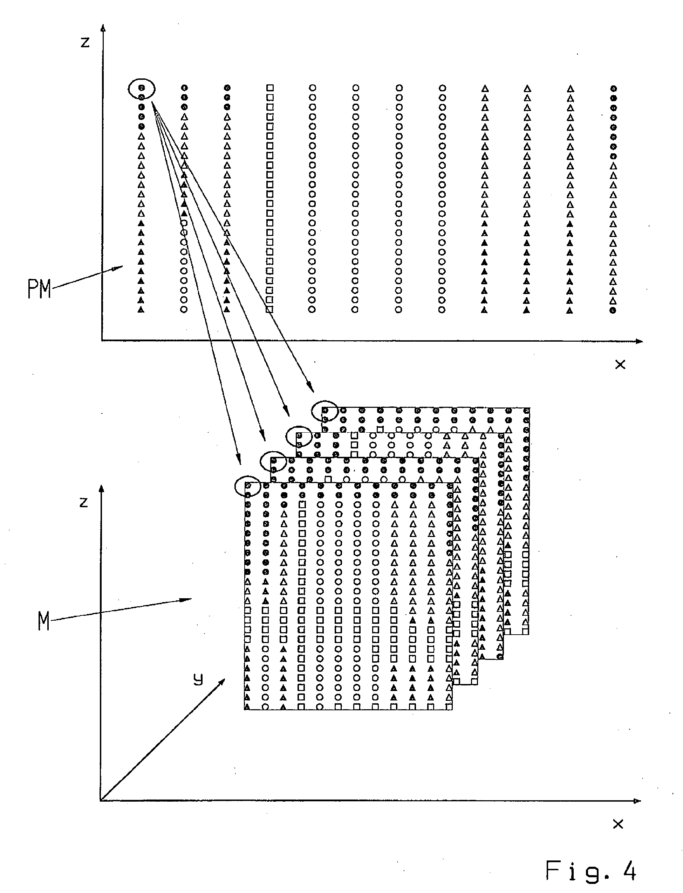

In einer weiteren Ausführungsform der erfindungsgemäßen Auswertung der Messmatrix M wird die entsprechende Charakteristik über eine für die Charakteristik spezifische Projektion der Messmatrix beschrieben. Unter Projektion ist dabei eine Mittelung der Barkhausenrausch-Signale der Messmatrix in geeigneten Ebenen gemäß der geometrischen Beschreibung des Zahnrads basierend auf dem Bauteilumfang x, dem Zahnprofil y und der Zahnradbreite z zu verstehen. In der Ausführungsform der Fig. 4 wird die Messmatrix M in die Ebene der x-Achse und z-Achse projiziert, d.h. die Barkhausenrausch-Signale für gleiche x- und z-Werte, jedoch für unterschiedliche Zahnprofile bzw. Messlinien y werden gemittelt. Dabei macht man sich die Erkenntnis zunutze, das bei einer solchen Mittelung Rundlauffehler weiterhin gut zu erkennen sind, denn die Mittelung erfolgt nicht über unterschiedliche Umfangspositionen des Bauteils hinweg. In Fig. 4 ist im oberen Teil die über die Mittelung entstandene Projektionsmatrix PM wiedergegeben. Dabei ist durch vier Pfeile für den obersten linken Eintrag der Matrix PM angedeutet, welche Barkhausenrausch-Signale zur Mittelung herangezogen werden. Man erkennt, dass diese Signale die gleiche Zahnflanke und die gleiche Zahnbreite, jedoch unterschiedliche Messlinien betreffen.

Mathematisch kann die Projektionsmatrix PM wie folgt beschrieben werden:

$$PM = \begin{bmatrix} \overline{s_{1,0,1}} & \cdot & \cdot & \overline{s_{1,0,w}} \\ \cdot & \cdot & \cdot & \cdot \\ \cdot & \cdot & \cdot & \cdot \\ \overline{s_{u,0,1}} & \cdot & \cdot & \overline{s_{u,0,w}} \end{bmatrix} \qquad (5).$$

Dabei repräsentiert $\overline{s_{u,0,w}}$ den Mittelwert der Barkhausenrausch-Signale von allen Messpunkten mit den Koordinaten $x_u$ und $z_w$.

Für andere Charakteristika können in geeigneter Weise ebenfalls Projektionsmatrizen definiert werden. Zum Beispiel muss bei einem einseitigen Schleifen, bei dem in Richtung der Breite des Zahnrads an einem Rand mehr geschliffen wird als am anderen, darauf geachtet werden, dass die Mittelung nicht über unterschiedliche Zahnbreitenpositionen hinweg erfolgt.

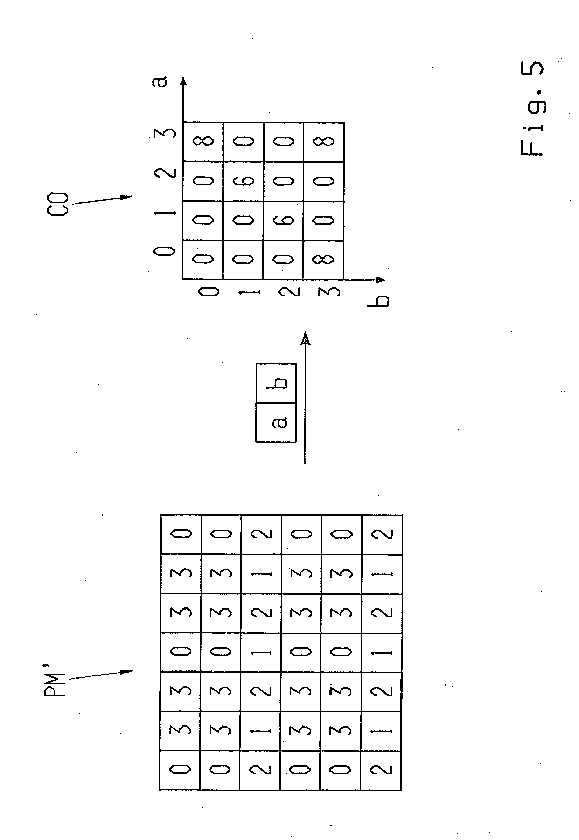

In einem nächsten Schritt werden nunmehr die Einträge der Matrix PM diskretisiert, so dass den Signalen in entsprechenden Wertebereichen diskrete Werte zugewiesen werden. Die Diskretisierung kann dabei in Analogie zur Legende aus Fig. 2 erfolgen. Aus dieser diskretisierten Matrix wird dann eine sog. Cooccurence-Matrix ermittelt, welche aus dem Gebiet der Bildverarbeitung bekannt ist und auch als Grauwertematrix bezeichnet wird. Fig. 5 verdeutlicht die Bildung einer Cooccurence-Matrix am Beispiel einer diskretisierten Matrix PM', welche vier Klassen 0, 1, 2 und 3 von Intensitäten der Barkhausenrausch-Signale umfasst, wobei ein höherer Wert der Klasse für eine höhere Intensität des Signals steht. Die Ermittlung der Cooccurence-Matrix CO läuft derart ab, dass für alle Einträge mit den entsprechenden, in Zeilenrichtung a aufgetragene Intensitätswerten 0 bis 3 bestimmt wird, wie viele rechte Nachbarn mit entsprechenden, in Spaltenrichtung b aufgetragenen Intensitätswerten 0 bis 3 vorliegen. Das heißt, es wird für alle Einträge eines Intensitätswerts bestimmt, wie viele nächste Nachbarn es mit einem bestimmten Intensitätswert gibt. In Fig. 5 bezeichnet somit der Eintrag in der rechten oberen Ecke der Cooccurence-Matrix CO die Häufigkeit, mit der ein Eintrag mit Intensitätswert 3 einen rechten Nachbarn mit einem Eintrag mit Intensitätswert 0 aufweist. Durch die Cooccurence-Matrix lassen sich somit starke Veränderungen in den Intensitäten des Barkhausenrausch-Signals erkennen, wobei solche starken Veränderungen durch große Einträge in der Cooccurence-Matrix für Elemente entfernt von der Diagonalen der Matrix repräsentiert werden.

Zur Auswertung der Cooccurence-Matrix wird diese in einem nächsten Schritt mit einer Gewichtungsmatrix GM multipliziert, welche die Tatsache berücksichtigt, dass eine gemäß der oben beschriebenen Projektion festgelegte Charakteristik dann vorliegt, wenn starke Veränderungen des Barkhausen-Rauschens auftreten.

Nachfolgend ist ein Beispiel einer geeigneten Gewichtungsmatrix GM für die Cooccurence-Matrix CO der Fig. 5 wiedergegeben:

$$GM = \begin{bmatrix} 0 & 1 & 2 & 3 \\ 1 & 0 & 1 & 2 \\ 2 & 1 & 0 & 1 \\ 3 & 2 & 1 & 0 \end{bmatrix} \qquad (6).$$

Man erkennt, dass Einträge mit größerem Abstand zur Diagonalen immer stärker gewichtet werden, wohingegen die Einträge entlang der Diagonalen den Wert 0 aufweisen.

Nach der Multiplikation der Cooccurence-Matrix CO mit der Matrix GM erhält man schließlich eine absolute Ausprägungsstärke der Charakteristik dadurch, dass die Determinante der multiplizierten Matrizen det(CO*GM) gebildet wird. Die Ausprägungsstärke bzw. die Wahrscheinlichkeit kann wieder in Bezug auf alle Charakteristika relativiert werden, indem die Determinante durch die Summe der Determinanten aller Charakteristika geteilt wird. Dies kann mathematisch wie folgt beschrieben werden:

$$W_i = \frac{\det(CO*GM)}{\sum_1^n \det(CO*GM)} \qquad (8).$$

Im Nenner wird über alle möglichen Charakteristika summiert. Dabei ist zu berücksichtigen, dass die Matrix CO im Nenner für jede Charakteristik unterschiedlich ausschaut, auch wenn in obiger Formel immer die gleichen Bezeichnungen für diese Matrix verwendet werden.

Die im Vorangegangenen beschriebenen Ausführungsformen der Erfindung weisen eine Reihe von Vorteilen auf. Insbesondere werden die für ein Bauteil erfassten Barkhausenrausch-Signale in Abhängigkeit von Charakteristika ausgewertet, welche Ursachen von Schleifbrand bzw. Prozessfehler darstellen. Über die entsprechenden Ausprägungsstärken können diese Ursachen im Rahmen der Auswertung erkannt werden und nachfolgend Maßnahmen eingeleitet werden, um Schleifbrand bzw. Prozessfehlern in den vorhergehenden Fertigungsschritten des Bauteils entgegenzuwirken. Dabei können nicht nur schleifbrandgeschädigte Bauteile rechtzeitig erkannt werden, sondern die gesamte Fertigungskette kann optimiert werden.

Bezugszeichen

| 1 | Bauteil |
|---|---|
| 101,102 | Zähne |
| M1, M2, M3, M4 | Messlinien |
| h, $b_M/2$, x | Höhenangaben |
| PS1, PS2, ..., PS9 | Messpositionen |
| x | Zahnflanke |
| y | Zahnprofil |
| z | Zahnradbreite |
| M | Messmatrix |
| C5, C6, C7, C8 | Spalten in der Korrekturmatrix |
| KM | Korrekturmatrix |
| PM | modifizierte Messmatrix |
| PM' | modifizierte und diskretisierte Messmatrix |
| CO | Cooccurence-Matrix |
| a | Zeile |
| b | Spalte |

**Patentansprüche**

1. Verfahren zur Prüfung eines Bauteils (1) basierend auf Barkhausenrauschen, bei dem eine Vielzahl von Barkhausenrausch-Signalen verarbeitet werden, welche an Messpositionen (PS1, PS2, ..., PS9) entlang der Oberfläche des Bauteils (1) mit einer Messvorrichtung erfasst wurden oder werden, **dadurch gekennzeichnet, dass** mittels einer Rechnereinheit

   aus den Messpositionen und den zugehörigen Barkhausenrausch-Signalen eine Messmatrix (M) gebildet wird, welche die erfassten Barkhausenrausch-Signale als Einträge enthält;
   eine Mehrzahl von Charakteristika vorgegeben wird, welche jeweils zumindest eine Ursache für Herstellungsfehler des Bauteils (1) repräsentieren, wobei jeder Charakteristik eine Verarbeitung der Messmatrix (M) zugeordnet ist, wobei die Verarbeitung spezifisch für die jeweilige Charakteristik ist;
   für jede Charakteristik die Messmatrix (M) der zugeordneten Verarbeitung unterzogen wird, wodurch eine Ausprägungsstärke der jeweiligen Charakteristik bestimmt wird.

2. Verfahren nach Anspruch 1, **dadurch gekennzeichnet, dass** das Bauteil (1) ein Zahnrad ist, wobei die Messpositionen (PS1, PS2, ..., PS9), an denen die Barkhausenrausch-Signale erfasst werden oder wurden, dreidimensionale Messpositionen (PS1, PS2, ..., PS9) sind, welche die Dimension Zahnradumfang (x), Zahnprofil (y) und Zahnradbreite (z) umfassen, wobei der Zahnradumfang (x) Zahnflanken (101, 102) oder Zahnlücken entlang des Zahnradumfangs spezifiziert, wobei das Zahnprofil (y) Messlinien (M1, M2, M3, M4) für eine Zahnlücke oder eine Zahnflanke (101, 102) spezifiziert und wobei die Zahnradbreite (z) Breitenpositionen in Richtung der Breite des Zahnrads (1) spezifiziert.

**3.** Verfahren nach Anspruch 1 oder 2, **dadurch gekennzeichnet, dass** die Charakteristika eine oder mehrere der folgenden Ursachen definieren: Rundlauffehler, einseitiges Schleifen, unbearbeitete Stellen, Aufmaßschwankungen, Härteverzüge, abweichende Bauteiloberflächenwerte, Werkzeugabnutzung.

**4.** Verfahren nach einem der vorhergehenden Ansprüche, **dadurch gekennzeichnet, dass** die der jeweiligen Charakteristik zugeordnete Verarbeitung derart ausgestaltet ist, dass eine für die jeweilige Charakteristik spezifische Korrekturmatrix (KM) mit Korrekturwerten für jeden Eintrag der Messmatrix (M) vorgegeben ist und die Summe aus den mit den Korrekturwerten multiplizierten Einträgen der Messmatrix (M) gebildet wird, wobei die Summe eine absolute Ausprägungsstärke der jeweiligen Charakteristik darstellt.

**5.** Verfahren nach Anspruch 4 in Kombination mit Anspruch 2 und 3, **dadurch gekennzeichnet, dass** für die Charakteristik Rundlauffehler die Korrekturwerte für alle Barkhausenrausch-Signale mit Messpositionen (PS1, PS2, ..., PS9) in einem vorbestimmten Umfangsbereich auf Eins und ansonsten auf Null gesetzt sind und/oder dass für die Charakteristik einseitiges Schleifen die Korrekturwerte von einer Zahnflanke zur nächsten zwischen Null und Eins wechseln und innerhalb einer Zahnflanke gleich sind oder die Korrekturwerte an einem Randbereich der Zahnradbreite auf Eins und ansonsten auf Null gesetzt sind.

**6.** Verfahren nach einem der vorhergehenden Ansprüche, **dadurch gekennzeichnet, dass** die der jeweiligen Charakteristik zugeordnete Verarbeitung einen Modifikationsschritt umfasst, gemäß dem eine modifizierte Messmatrix (PM) durch eine Mittelung von Barkhausenrausch-Signalen für eine Anzahl von Messpositionen (PS1, PS2, ..., PS9) entlang der Oberfläche des Bauteils (1) bestimmt wird, wobei die Anzahl von Messpositionen (PS1, PS2, ..., PS9) für die jeweilige Charakteristik spezifisch ist.

**7.** Verfahren nach Anspruch 6 in Kombination mit Anspruch 2 und 3, **dadurch gekennzeichnet, dass** für die Charakteristik Rundlauffehler die Anzahl von Messpositionen (PS1, PS2, ..., PS9), deren Barkhausenrausch-Signale gemittelt werden, ausschließlich Messpositionen (PS1, PS2, ..., PS9) betreffend die gleiche Zahnflanke (101, 102) oder Zahnlücke sind und/oder für die Charakteristik einseitiges Schleifen die Anzahl von Messpositionen (PS1, PS2, ..., PS9), deren Barkhausenrausch-Signale gemittelt werden, ausschließlich Messpositionen (PS1, PS2, ..., PS9) betreffend die gleiche Zahnflanke (101, 102) oder die gleiche Breitenposition der Zahnradbreite (z) sind.

**8.** Verfahren nach Anspruch 6 oder 7, **dadurch gekennzeichnet, dass** die der jeweiligen Charakteristik zugeordnete Verarbeitung neben dem Modifikationsschritt einen Verarbeitungsschritt umfasst, gemäß dem die Einträge der modifizierten Messmatrix (PM) diskretisiert werden und eine Cooccurrence-Matrix (CO) für die Häufigkeiten von Wertekombinationen benachbarter Einträge der modifizierten und diskretisierten Messmatrix (PM') bestimmt wird, wobei die Cooccurence-Matrix (CO) mit einer Gewichtungsmatrix multipliziert wird, welche große Änderungen in den Werten benachbarter Einträge der modifizierten und diskretisierten Messmatrix (PM') höher gewichtet, wobei die Determinante des Multiplikationsergebnisses bestimmt wird, welche eine absolute Ausprägungsstärke für die jeweilige Charakteristik darstellt.

**9.** Verfahren einem der vorhergehenden Ansprüche in Kombination mit Anspruch 4 oder 8, **dadurch gekennzeichnet, dass** aus der absoluten Ausprägungsstärke einer jeweiligen Charakteristik eine relative Ausprägungsstärke ermittelt wird, indem die absolute Ausprägungsstärke der jeweiligen Charakteristik durch die Summe der absoluten Ausprägungsstärken aller Charakteristika geteilt wird.

**10.** Vorrichtung zum Prüfen eines Bauteils (1) basierend auf Barkhausenrauschen unter Verwendung einer Vielzahl von Barkhausenrausch-Signalen, welche an Messpositionen (PS1, PS2, ..., PS9) entlang der Oberfläche des Bauteils (1) mit einer Messvorrichtung erfasst wurden oder werden, **dadurch gekennzeichnet, dass** die Vorrichtung eine Rechnereinheit umfasst, welche derart ausgestaltet ist, dass in deren Betrieb

aus den Messpositionen und den zugehörigen Barkhausenrausch-Signalen eine Messmatrix (M) gebildet wird, welche die erfassten Barkhausenrausch-Signale als Einträge enthält;
eine Mehrzahl von Charakteristika vorgegeben wird, welche jeweils zumindest eine Ursache für Herstellungsfehler des Bauteils (1) repräsentieren, wobei jeder Charakteristik eine Verarbeitung der Messmatrix (M) zugeordnet ist, wobei die Verarbeitung spezifisch für die jeweilige Charakteristik ist;

für jede Charakteristik die Messmatrix (M) der zugeordneten Verarbeitung unterzogen wird, wodurch eine Ausprägungsstärke der jeweiligen Charakteristik bestimmt wird.

**11.** Vorrichtung nach Anspruch 10, **dadurch gekennzeichnet, dass** die Vorrichtung zur Durchführung eines Verfahrens nach einem der Ansprüche 2 bis 9 ausgestaltet ist.

**Claims**

**1.** Method for inspecting a component (1) on the basis of Barkhausen noises, in which a plurality of Barkhausen noise signals are processed, which have been or are determined at measurement positions (PS1, PS2, ..., PS9) along the surface of the component (1) by means of a measuring device, **characterized in that** by means of a computer unit from the Barkhausen noise signals a measurement matrix (M) is formed, which contains the detected Barkhausen noise signals as entries;

a plurality of characteristics are specified, each of which represents at least one cause of manufacturing defects of the component (1), and each characteristic is associated with a processing procedure of the measurement matrix (M), the procedure being specific for the respective characteristic;

for each characteristic the measurement matrix (M) undergoes the associated processing procedure, whereby an intensity of the characteristic concerned is determined.

**2.** Method according to Claim 1, **characterized in that** the component (1) is a gearwheel, the measurement positions (PS1, PS2, ..., PS9) at which the Barkhausen noise signals are or have been detected are three-dimensional measurement positions (PS1, PS2, ..., PS9) that cover the dimensions of gearwheel circumference (x), tooth profile (y) and gearwheel width (z), wherein the gearwheel circumference (x) specifies tooth flanks (101, 102) or tooth gaps along the circumference of the gearwheel, the tooth profile (y) specifies measurement lines (M1, M2, M3, M4) for a tooth gap or a tooth flank (101, 102), and the gearwheel width (z) specifies width positions in the direction of the width of the gearwheel (1).

**3.** Method according to Claims 1 or 2, **characterized in that** the characteristics define one or more of the following causes: concentricity errors, one-sided grinding, unmachined positions, dimensional fluctuations, hardening distortions, deviant component surface values, tool wear.

**4.** Method according to any of the preceding claims, **characterized in that** the processing procedure associated with a respective characteristic is designed such that a correction matrix (KM) specific for the characteristic concerned is specified, which contains correction values for each entry of the measurement matrix (M), and the sum of the entries of the measure matrix (M) multiplied by the correction values is formed, such that the sum represents an absolute intensity of the characteristic concerned.

**5.** Method according to Claim 4 in combination with Claims 2 and 3, **characterized in that** for the characteristic of concentricity error the correction values for all the Barkhausen noise signals measured at positions (PS1, PS2, ..., PS9) within a predetermined circumferential region are set to one or otherwise to zero, and/or for the characteristic of one-sided grinding the correction values alternate between zero and one from one tooth flank to the next, whereas within a tooth flank they remain the same or the correction value at an edge area of the gearwheel's width is set at one and is otherwise zero.

**6.** Method according to any of the preceding claims, **characterized in that** the processing procedure associated with each respective characteristic comprises a modification step in accordance with which a modified measurement matrix (PM) is determined by averaging Barkhausen noise signals from a number of measurement positions (PS1, PS2, ..., PS9) along the surface of the component (1), the number of measurement positions (PS1, PS2, ..., PS9) being specific for each characteristic.

**7.** Method according to Claim 6 in combination with Claims 2 and 3, **characterized in that** for the characteristic of concentricity error the measurement positions (PS1, PS2, ..., PS9) whose Barkhausen noise signals are averaged are exclusively measurement positions (PS1, PS2, ..., PS9) that relate to the same tooth flank (101, 102) or tooth gap, and/or for the characteristic of one-sided grinding the measurement positions (PS1, PS2, ..., PS9) whose Barkhausen noise signals are averaged are exclusively measurement positions (PS1, PS2, ..., PS9) relating to the same tooth flank (101, 102) or the same width position of the gearwheel width (z).

8. Method according to Claims 6 or 7, **characterized in that** besides the modification step, the processing procedure associated with each characteristic comprises a processing step in which the entries of the modified measurement matrix (PM) are discretized and a co-occurrence matrix (CO) is determined for the frequencies of value combinations of neighboring entries in a modified and discretized measurement matrix (PM'), the co-occurrence matrix (CO) then being multiplied by a weighting matrix which assigns greater weight to large changes in the values of neighboring entries in the modified and discretized measurement matrix (PM'), and the determinant of the multiplication result is calculated, this determinant representing an absolute intensity of the respective characteristic concerned.

9. Method according to any of the preceding claims in combination with Claims 4 or 8, **characterized in that** from the absolute intensity of any characteristic a relative intensity is determined by dividing the absolute intensity of the characteristic by the sum of the absolute intensities of all the characteristics.

10. Device for inspecting a component (1) on the basis of Barkhausen noises using a plurality of Barkhausen noise signals that have been or are determined at measurement positions (PM1, PS2, ..., PS9) along the surface of the component (1) by means of a measuring device, **characterized in that** the device comprises a computer unit designed so that during its operation from the Barkhausen noise signals a measurement matrix (M) is formed, which contains the Barkhausen noise signals as entries;
a plurality of characteristics are specified, each of which represents at least one cause of manufacturing defects of the component (1), and each characteristic is associated with a processing procedure of the measurement matrix (M), the procedure being specific for the characteristic concerned;
for each characteristic the measurement matrix (M) undergoes the associated processing procedure, whereby an intensity of the characteristic is determined.

11. Device according to Claim 10, **characterized in that** the device is designed to carry out a method according to any of Claims 2 to 9.

**Revendications**

1. Procédé d'inspection d'une pièce (1) sur la base du bruit Barkhausen, dans lequel on traite une pluralité de signaux de bruit Barkhausen qui ont été ou sont détectés à des positions de mesure (PS1, PS2, ..., PS9) le long de la surface de la pièce (1) au moyen d'un dispositif de mesure,
**caractérisé en ce qu'**on construit, au moyen d'une unité de calcul, à partir des positions de mesure et des signaux de bruit Barkhausen associés, une matrice de mesure (M) qui contient en tant qu'entrées les signaux de bruit Barkhausen détectés;
on prédéfinit une pluralité de caractéristiques qui représentent chacune au moins une cause d'erreur de fabrication de la pièce (1), dans lequel à chaque caractéristique est associé un traitement de la matrice de mesure (M), dans lequel le traitement est spécifique de la caractéristique respective;
pour chaque caractéristique, on soumet la matrice de mesure (M) au traitement associé, cela permettant de déterminer une intensité d'expression de la caractéristique respective.

2. Procédé selon la revendication 1, **caractérisé en ce que** la pièce (1) est une roue dentée, dans lequel les positions de mesure (PS1, PS2, ..., PS9) auxquelles les signaux de bruit Barkhausen sont ou ont été détectés sont des positions de mesure tridimensionnelle (PS1, PS2, ..., PS9) qui comprennent les dimensions de circonférence de roue dentée (x), de profil de dent (y) et de largeur de roue dentée (z), dans lequel la circonférence de roue dentée (x) spécifie des flancs de dents (101, 102) ou des entredents le long de la circonférence de la roue dentée, dans lequel le profil de dent (y) spécifie des lignes de mesure (M1, M2, M3, M4) pour un entredent ou un flanc de dent (101, 102) et dans lequel la largeur de roue dentée (z) spécifie des positions en largeur dans la direction de la largeur de la roue dentée (1).

3. Procédé selon la revendication 1 ou 2, **caractérisé en ce que** les caractéristiques définissent une ou plusieurs des causes suivantes : une erreur de concentricité, un affutage unilatéral, des points non travaillés, des fluctuations de dimensions, une déformation au durcissement, des écarts affectant les valeurs de surface de la pièce, l'usure des outils.

4. Procédé selon l'une quelconque des revendications précédentes, **caractérisé en ce que** le traitement associé à la caractéristique respective est conçu de manière à ce qu'une matrice de correction (KM) spécifique de la caractéristique respective soit prédéterminée avec des valeurs de correction pour chaque entrée de la matrice de mesure (M) et **en ce que** la somme est formée à partir des entrées de la matrice de mesure (M) multipliées par des valeurs de correction, dans lequel la somme représente une intensité d'expression absolue de la caractéristique respective.

5. Procédé selon la revendication 4 associée aux revendications 2 et 3, **caractérisé en ce que**, pour la caractéristique d'erreur de concentricité, les valeurs de correction correspondant à tous les signaux de bruit Barkhausen ayant des positions de mesure (PS1, PS2, ..., PS9) dans une région circonférentielle prédéterminée sont mis à un et sont autrement mises à zéro et/ou **en ce que** pour la caractéristique d'affutage unilatéral, les valeurs de correction alternent entre zéro et un d'un flanc de dent au suivant et **en ce qu'**elles restent constantes à l'intérieur d'un flanc de dent ou **en ce que** les valeurs de correction sont mises à un dans une région de bord de la largeur de roue dentée et sont autrement mises à zéro.

6. Procédé selon l'une quelconque des revendications précédentes, **caractérisé en ce que** le traitement associé à la caractéristique respective comprend une étape de modification conformément à laquelle on détermine une matrice de mesure modifiée (PM) en moyennant des signaux de bruit Barkhausen pour un certain nombre de positions de mesure (PS1, PS2, ..., PS9) le long de la surface de la pièce (1), dans lequel le nombre de positions de mesure (PS1, PS2, ..., PS9) est spécifique de la caractéristique respective.

7. Procédé selon la revendication 6 associée aux revendications 2 et 3, **caractérisé en ce que**, pour la caractéristique d'erreur de concentricité, le nombre de positions de mesure (PS1, PS2, ..., PS9), dont les signaux de bruit Barkhausen sont moyennés, sont exclusivement des positions de mesure (PS1, PS2, ..., PS9) concernant des flancs de dents (101, 102) ou des entredents identiques, et/ou **en ce que**, pour la caractéristique d'affutage unilatéral, le nombre de positions de mesure (PS1, PS2, ..., PS9) dont les signaux de bruit Barkhausen sont moyennés sont exclusivement des positions de mesure (PS1, PS2, ..., PS9) concernant des flancs de dents identiques (101, 102) ou une même position en largeur de la largeur de roue dentée (z).

8. Procédé selon la revendication 6 ou 7, **caractérisé en ce que** le traitement associé à la caractéristique respective comprend, outre l'étape de modification, une étape de traitement conformément à laquelle on discrétise les entrées de la matrice de mesure modifiée (PM) et on détermine une matrice de cooccurrence (CO) pour les fréquences de combinaisons de valeurs d'entrées voisines de la matrice de mesure modifiée et discrétisée (PM'), dans lequel on multiplie la matrice de cooccurrence (CO) par une matrice de poids qui pondère plus fortement les fortes variations des valeurs d'entrées voisines de la matrice modifiée et discrétisée (PM'), dans lequel on détermine le déterminant du résultat de la multiplication qui représente une intensité d'expression absolue pour la caractéristique respective.

9. Procédé selon l'une quelconque des revendications précédentes associée aux revendications 4 ou 8, **caractérisé en ce qu'**on détermine une intensité d'expression relative à partir de l'intensité d'expression absolue d'une caractéristique respective en divisant l'intensité d'expression absolue de la caractéristique respective par la somme des intensités d'expression absolues de toutes les caractéristiques.

10. Dispositif d'inspection d'une pièce (1) sur la base du bruit Barkhausen par utilisation d'une pluralité de signaux de bruit Barkhausen qui ont été ou sont détectés à des positions de mesure (PS1, PS2, ..., PS9) le long de la surface de la pièce (1) au moyen d'un dispositif de mesure,
**caractérisé en ce que** le dispositif comprend une unité de calcul qui est conçue de manière à ce que, lors de son fonctionnement,
on construise, à partir des positions de mesure et des signaux de bruit Barkhausen associés, une matrice de mesure (M) qui contient en tant qu'entrées les signaux de bruit Barkhausen détectés;
on prédéfinit une pluralité de caractéristiques qui représentent respectivement au moins une cause d'erreurs de fabrication de la pièce (1), dans lequel, à chaque caractéristique est associé un traitement de la matrice de mesure (M), dans lequel le traitement est spécifique de la caractéristique respective ;
pour chaque caractéristique, on soumet la matrice de mesure (M) au traitement associé, cela permettant de déterminer une intensité d'expression de la caractéristique respective.

11. Dispositif selon la revendication 10, **caractérisé en ce que** le dispositif est conçu pour mettre en oeuvre un procédé selon l'une quelconque des revendications 2 à 9.

Fig. 1

| | |
|---|---|
| • | ~30 mp |
| △ | 30~35 mp |
| ▲ | 35~40 mp |
| □ | 40~45 mp |
| ○ | 45~60 mp |

Fig. 2

Fig. 3

Fig. 4

PM'

CO

| | 0 | 1 | 2 | 3 | 0 | 3 | 3 | 0 |
|---|---|---|---|---|---|---|---|---|
| | 0 | 3 | 3 | 0 | 3 | 3 | 0 | |
| | 0 | 3 | 3 | 0 | 3 | 3 | 0 | |
| | 2 | 1 | 2 | 1 | 2 | 1 | 2 | |
| | 0 | 3 | 3 | 0 | 3 | 3 | 0 | |
| | 0 | 3 | 3 | 0 | 3 | 3 | 0 | |
| | 2 | 1 | 2 | 1 | 2 | 1 | 2 | |

| a | b |
|---|---|

a →

|   | 0 | 1 | 2 | 3 |
|---|---|---|---|---|
| 0 | 0 | 0 | 0 | 8 |
| 1 | 0 | 0 | 6 | 0 |
| 2 | 0 | 6 | 0 | 0 |
| 3 | 8 | 0 | 0 | 8 |

b ↓

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0100009 A1
- DE 4333830 A1